# EUROPEAN PATENT SPECIFICATION

(11) **EP 0 956 749 B1**
(45) Date of publication and mention of the grant of the patent: **27.05.2015**
(21) Application number: 98901469.1
(22) Date of filing: 06.01.1998
(51) Int. Cl.: H01L 23/29, H05K 9/00, H01L 23/552, H01L 23/31

(54) **METHODS AND COMPOSITIONS FOR IONIZING RADIATION SHIELDING**
VERFAHREN UND ZUSAMMENSETZUNGEN ZUM SCHUTZ GEGEN IONISIERENDE STRAHLUNG
PROCEDES ET COMPOSITIONS POUR LA PROTECTION CONTRE LES RAYONS IONISANTS

(30) Priority: 30.01.1997 US 791256
(43) Date of publication of application: 17.11.1999
(73) Proprietor: Maxwell Technologies, Inc., San Diego, CA 92123 (US)
(72) Inventor: FEATHERBY, Michael, San Diego, CA 92117 (US); STROBEL, David, J., Poway, CA 92064 (US); LAYTON, Phillip, J., San Diego, CA 92130 (US); LI, Edward, San Diego, CA 92117 (US)
(74) Representative: Simonnet, Christine
(86) International application number: PCT/IB1998/000207
(87) International publication number: WO 1998/034451

(56) References cited:
- EP-A- 0 154 271
- FR-A- 2 570 001
- FR-A- 2 584 853
- FR-A- 2 669 142
- GB-A- 1 291 721
- US-A- 5 160 374
- US-A- 5 202 536
- US-A- 5 304 750
- US-A- 5 561 265

## Description

### BACKGROUND OF THE INVENTION

### Technical Field

The present invention relates in general to a radiation shielding structure and a method of making it. The invention more particularly relates to shielding microelectronic devices, with a radiation-hardened light weight coating for withstanding the radiation hazards found in the space environment, as well as other less hazardous environments.

### Background Art

Many of today's commercial integrated circuit (IC) devices and multi-chip modules (MCM) cannot be utilized in deep space and earth orbiting applications because of total dose radiation induced damage. Commercial IC devices are developed and manufactured for computer and mass market applications and are not designed to withstand the effects of the natural space environment. The radiation effects include solar flares, galactic cosmic radiation and the Van Allen trapped electron and proton belts or man-made radiation induced events (neutrons and gamma radiation).

Typical commercial silicon integrated circuits fail to operate when exposed to total doses of two to fifteen kilorads(Si). Common methods used to prevent radiation degradation in performance are: 1) to design special radiation tolerant die, 2) to shield the entire component and board assembly, or 3) shield the individual component. There are weight, cost and time-to-market penalties depending on the method. For example, specially designed radiation tolerant die are time consuming and expensive to produce, since the part must be redesigned to incorporate radiation hardening techniques. Examples of such methods include U.S. patents 3,933,530; 4,014,772; 4,148,049; 4,313,7684; 4,402,002; 4,675,978; 4,825,278; 4,833,334; 4,903,108; 5,001,528; 5,006,479; 5,024,965; 5,140,390; 5,220,192; and 5,324,952. Reference may also be made to Japan patent application 62-125651, June 6, 1987, and articles entitled "Effects of Material and/or Structure on Shielding of Electronic Devices," R. Mangeret, T. Carriere, J. Beacour, T.M. Jordan, IEEE 1996; and "Novice, a Radiation Transport/Shielding Code", T.M. Jordan, E.M.P. Consultants Report, January 1960.

Such techniques delay the time to market the products. As a result, these conventional radiation hardened devices are usually two to three generations behind the current commercial technological advances in both size and capabilities. There are additional penalties in limited marketability and demand, and hence low volume productions of the die result. Consequently, such methods produce a more expensive product, which is technologically behind the commercially available microelectronics, with slower speed and less capability. Additionally, because of the limited market for these products, they are frequently not available at all.

Such radiation shielding methods involve using metal shielding external to the package. Shielding by other mechanical or electrical elements complicates the platform design, often requiring complex three dimensional modeling of the design.

Another attempt at shielding includes disposing a small shield on the surface of the package. Such a technique does not provide effective three-dimensional shielding protection. Additionally, the small external shield is generally thermally mismatched to the package, and increases the size and weight of the package.

Examples of system level shielding are disclosed in U.S. patents 4,833,334 and 5,324,952. The patent 4,833,334 discloses the use of a protective box to house sensitive electronic components. The box is partially composed of a high atomic weight material to shield effectively against x-rays. However this approach has the serious disadvantage of adding substantial bulk and weight to electronic circuit assemblies protected in this manner. Moreover, it would be expensive to provide this type of protection to individual integrated circuits as manufacturing custom boxes for each circuit configuration would be costly.

The method of shielding material on the outside of the package is known as spot shielding. Such a technique is disclosed in Japanese patent application 62-125651, published June 6, 1987. This patent describes a spot shielded semiconductor device which utilizes a double layered shield film to serve as a sealing cover on an upper surface of a semiconductor package. Another double layered shield film is attached to a lower surface of the package. However, space qualified microelectronic parts must be capable of withstanding the enormous forces exerted during acceleration periods during space travel. The external shields are subject to tearing or prying off from the sealing cover. The use of a double layer shield film only slightly reduces the weight of the package, but increases the size of the package unnecessarily. Also, thin films are generally only effective at shielding electromagnetic interference (EMI) radiation and are ineffective at shielding ionizing radiation found in space. Examples of this type of EMI or EMF shielding devices include devices disclosed in U.S patents 4, 266,239; 4, 823, 523; and 4, 868, 716.

The significant disadvantage of the spot shielding method includes an increase in weight and thickness of the device, and an increase in exposure of the semiconductor to side angle radiation due to the shielding being spaced apart from the semiconductor.

A far superior method of shielding involves using an integrated shield, where the package itself is the shield. For example, reference may be made to said U.S Patent N° 5, 635, 754, issued June 3, 1997, entitled "RADIATION SHIELDING OF INTERGRATED CIRCUITS AND MULTI-CHIP MODULES IN CERAMIC AND METAL PACKAGES".

The material In the package and the package design is optimized for the natural space radiation environment.

Many conventional microcircuits are only available in prepackaged form, or the die is already mounted onto the circuit board. Therefore, it would be highly desirable to have technique and shielding compositions for shielding parts already packaged or mounted on a circuit board, or in bare IC die form. Such compositions should be relatively inexpensive to manufacture and use, and are compact in size. In this regard, such new and improved techniques should be very convenient to employ in a highly effective manner, and yet be relatively inexpensive to manufacture.

FR-A-2, 570, 001 discloses a method for depositing a material comprised mainly of a metal, an alloy, boron and/or ceramic matter, wherein particles of a metal, an alloy, boron and/or a ceramic matter are applied on a substrate and fixed together by an hydraulic or organic binder such that the weight ratio of the metal, alloy, boron and/or ceramic matter to the binder be at least 1.

FR-A-2,669, 142 discloses a coating composed of mixed high Z shielding particles and low Z particles.

FR-A-2, 584, 853 to Val discloses a structure having a plurality of layers comprising all a low Z material, wherein each layer comprises various densities of inserts in a high Z material.

### SUMMARY OF THE INVENTION

The principal object of the present invention is to provide a new and improved radiation shielding in outer space or other environments, whereby such shielding is highly effective and relatively inexpensive.

Another object of the present invention is to provide such a new and improved method, wherein the radiation tolerance of a circuit package to be shielded is greatly improved, and the shielding is provided in all axial directions.

A further object of the present invention is that satellite designers can utilize current generation IC technological advances, while improving delivery time.

A still further object of the present invention is that IC devices can be supplied relatively inexpensively due to use of commercially available dies at current market prices without undue weight, excessive or bulky sizes or other undesirable or unwanted design requirements.

Briefly the above and further objects of the present invention are realized by the radiation shielding structure of claim 1 and the method of claim 5.

A radiation shielding composition including densely filled conformal coating material is used for commercially available integrated circuits or grouping of circuits, to protect against natural and man-made radiation hazards of the spacecraft environment, whether in earth orbit, geostationary, or deep space probes.

The inventive structure and method are provided to facilitate the design and manufacture of microelectronics, and to coat externally a circuit package with a conformal coating to improve radiation tolerance to natural space radiation.

The conventional method of shielding using lead has two major disadvantages. Lead is highly toxic, which is a disadvantage in both manufacture and use. Lead is also relatively less dense. With the invention, the same equivalent shielding can be obtained with a thinner high Z material such as tungsten.

The limiting factor is weight, and the energy and species of radiation. Thin densely packed shields are not very effective on high energy electromagnetic radiation such as gamma rays, and high energy neutrons.

The present invention contemplates using both plastic or ceramic packaged microelectronic devices, and encapsulating or coating the outer surface of the device to provide shielding as required for the anticipated radiation environment. Since fluences of species and energy ranges of radiation vary in space, and since the optimal shielding varies depending on the species of radiation, the coating substance or material can be optimally tailored based on the anticipated radiation that irradiates the part to be protected. In all applications, the particles impregnated within the conformal coating substance are designed to achieve the highest tap density possible for the application.

The present inventive method preferably includes calculating/modeling the anticipated radiation spectrum, the required amount of shielding, as well as multiple layers of both high Z and low Z shielding material. The inventive conformal coating substance or material is then designed to meet that requirement. For a standard Geosynchronous Orbit, the optimum shielding entails a conformal coating having three layers; namely, a high Z layer sandwiched between two low Z layers. For marking and hermiticity, a layer of smooth unimpregnated coating material is applied to the top layer.

For integrated circuit devices that have already been packaged, the conformal coating material can be applied in various manners. These include, but are not restricted to, the following methods. One method relates to using a low pressure (or high pressure depending on the package strength and susceptibility) injection mold. The coating material is injected into a mold containing the packaged part. Another method involves "globbing" or putting a viscous conformal coating over a packaged part. The part can be disposed within a mold, or elsewhere when the shielding composition is applied. Another method involves spraying or painting on the coating composition. The optimum method is to coat all sides of the part uniformly with the shielding composition to shield all sides equally from isotropic radiation, and especially when the direction of the source of radiation is not known.

For multi-chip modules (MCMs) where there are multiple integrated circuits within a single package, the conformal coating composition is applied in a similar manner as in the monolithic packaged integrated circuit.

### BRIEF DESCRIPTION OF DRAWINGS

The above mentioned and other objects and features of this invention and the manner of attaining them will become apparent, and the invention itself will be best understood by reference to the following description of the embodiment of the invention in conjunction with the accompanying drawings, wherein:
FIG. 1 is a diagrammatic sectional side view of a prior art spot shielded prepackaged integrated circuit;
FIG. 2A is a diagrammatic sectional side view of a conventional unshielded commercial package assembly;
FIG. 2B is a diagrammatic top view of the package assembly of FIG. 2A;
FIG. 3 is a diagrammatic sectional side view of a prior art module with multiple integrated circuit devices shielded therewithin;
FIG. 4 is a flow chart illustrating a radiation shielding method;
FIG. 5 is a graph of a typical total dose versus depth curve, useful in understanding the present invention;
FIG. 6 is a diagrammatic sectional side view of a shielding composition applied to a conventional package;
FIG. 7 is a diagrammatic sectional side view of a shielding composition applied to a conventional chip-on board;
FIG. 8 is a diagrammatic sectional side view of a multilayered conformal coating of shielding composition applied to a conventional integrated circuit package in accordance with the present invention; and
FIG. 9 is a pictorial, partially diagrammatic fragmentary view of a shielding composition used for animal radiation shielding;

### BEST MODE FOR CARRYING OUT THE INVENTION

The following description is of the best mode presently contemplated for practicing the invention. This description is not to be taken in a limiting sense, but is made merely for the purpose of describing the general principles of the invention. The scope of the invention should be ascertained with reference to the issued claims. In the description that follows, like numerals or reference characters will be used to refer to like parts or elements throughout.

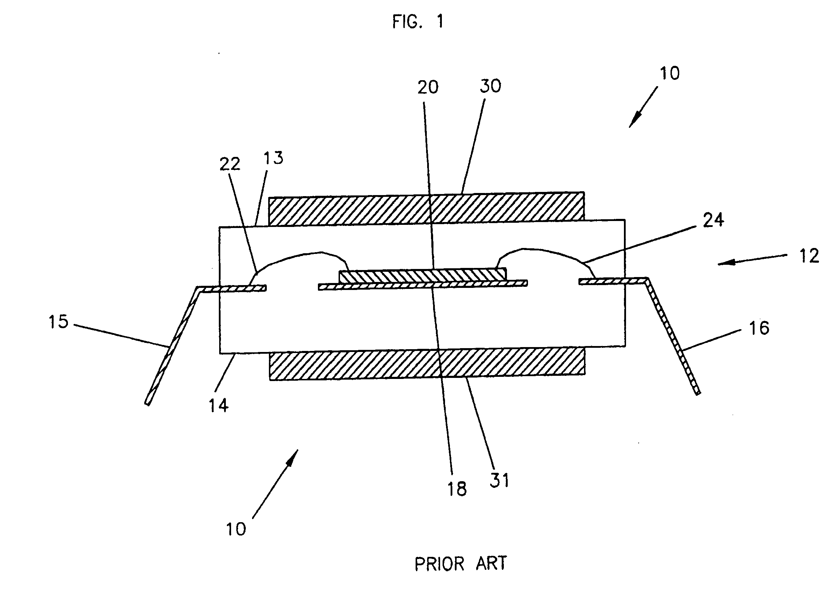

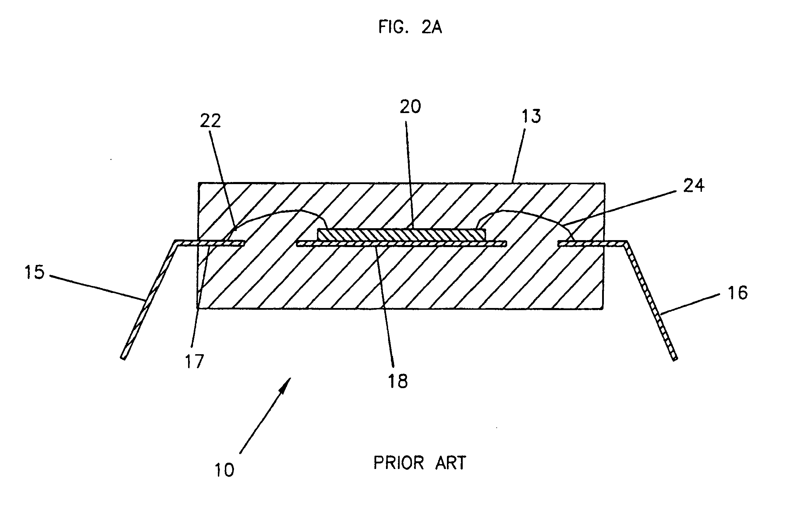

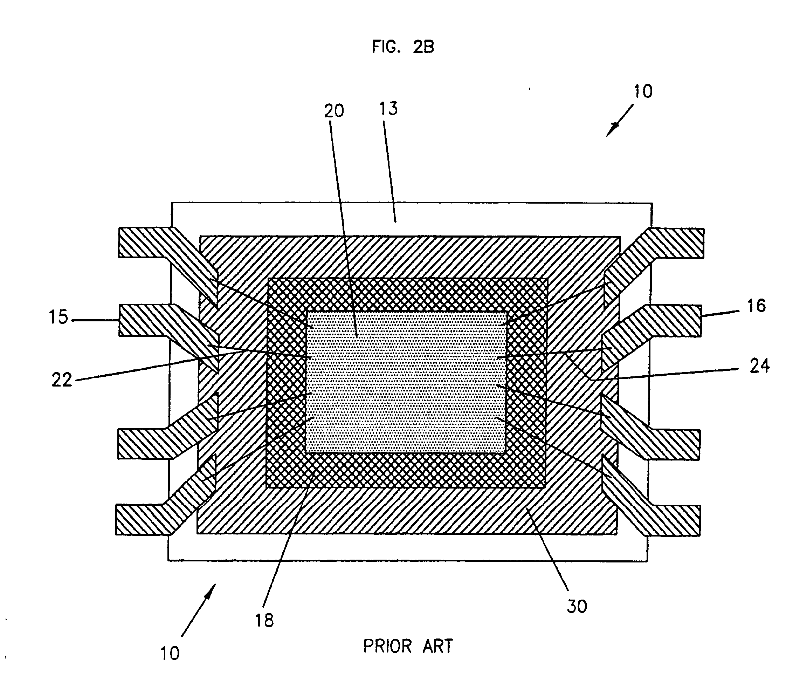

Referring now to the drawings, and more particularly to FIGS. 1, 2A and 2B, there is shown a commonly used conventional microelectronic package 10, which is a plastic package. FIG. 1 illustrates the package 10 with a spot shield attached. The packages are comprised of a die 20, which is composed of silicon or other semiconductor base. The die is generally attached to a die attach pad 18 for support. The die is then bonded with multiple lead wires 22, 24 to a lead frame with multiple leads 15, 16. This entire assembly is encased within a package 13 composed of suitable plastic material or other material such as ceramic.

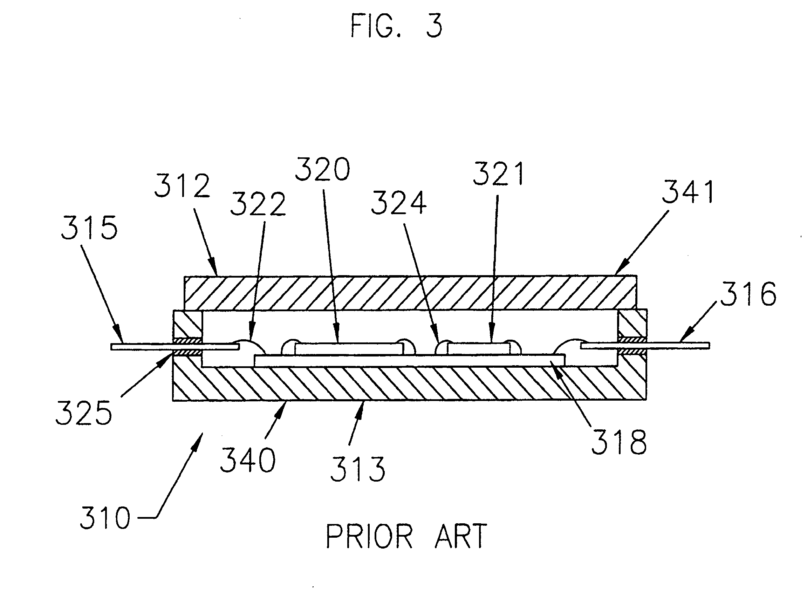

If thermal conductivity properties are important considerations, other materials such as ceramics are used, as shown in FIG. 3, these are more difficult to work with and can be conducting, necessitating an insulating feed through 25 to cover the leads 15, 16.

A conventional method for shielding these packages is shown in FIG. 1, where a pair of shielding plates 30 and 31, usually made of a high Z material such as tantalum, is attached to the top and bottom portions of the package 13 respectively by a suitable adhesive (not shown).

As shown in FIG. 3, another prior art technique relates to the use of integrated shielding technology, where the package itself, is part of the shielding. FIG. 3 shows the integrated shielding package 310 that also incorporates multiple die 320 and 321. The multiple die 320 and 321 on a die attach pad 318 employ multiple lead wires 322 and 324, together with a lead frame with multiple leads 315 and 316 and an insulating feed through 325, for a package 313. This type of package is called an MCM or Hybrid package. With multiple die within the package, the density of functions increases, while the overall weight required to accomplish the task is reduced. This type of packaging requires base members 340 and 341, which can be made of various shielding materials. For ionizing radiation, high Z materials can be used, enabling the package itself to become the radiation shielding.

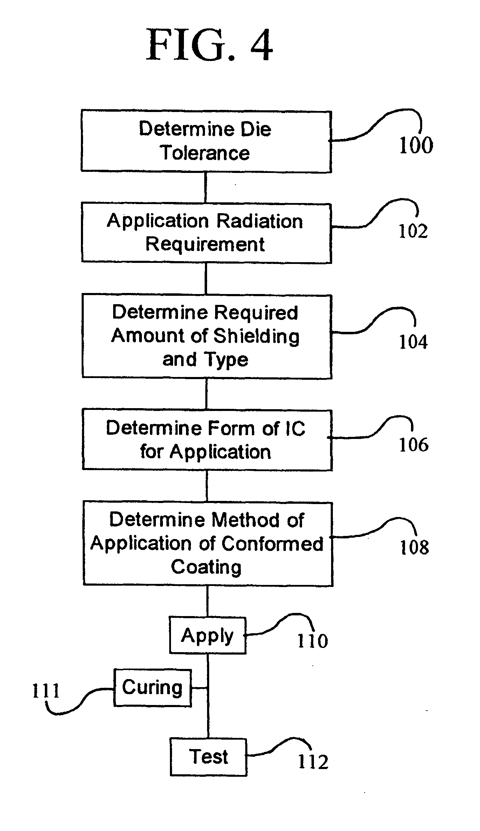

As shown in FIG. 4, a method includes, as indicated in box 100, determining the inherent radiation tolerance of the die to be shielded. This test can be accomplished by a Cobalt-60 source or other penetrating irradiation source. Without the knowledge of what the inherent radiation tolerance is for the individual semiconductor device, the designer does not know how much or whether shielding is necessary.

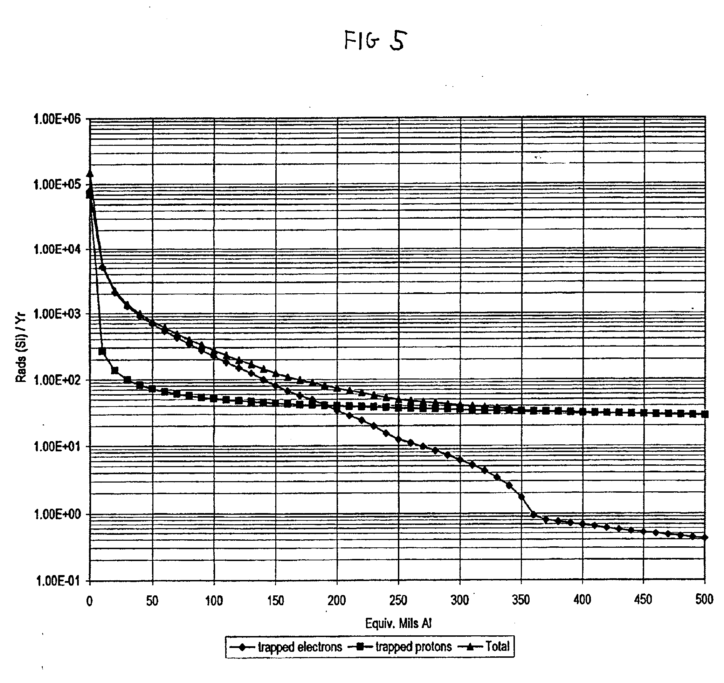

The next step as indicated at 102 involves determining the radiation spectrum and dose depth curve of the particular mission or radiation requirement of the application. For orbits around the earth, this is calculated using conventional radiation transport codes in conjunction with conventional radiation spectrum tables. The dose depth curve is generally represented as a total radiation dose versus thickness of equivalent aluminum shielding as shown in FIG. 5. Although not preferred, steps indicated at 100 and 102 can be omitted if the application is unknown and the designer desires only to enhance whatever the radiation tolerance of the integrated circuit to be protected.

Knowing the inherent radiation tolerance of the integrated circuit device, as indicated at 100 and the dose depth curve as indicated at 102, the amount of shielding required can be determined to bring the integrated circuit device within tolerance as indicated at 104.

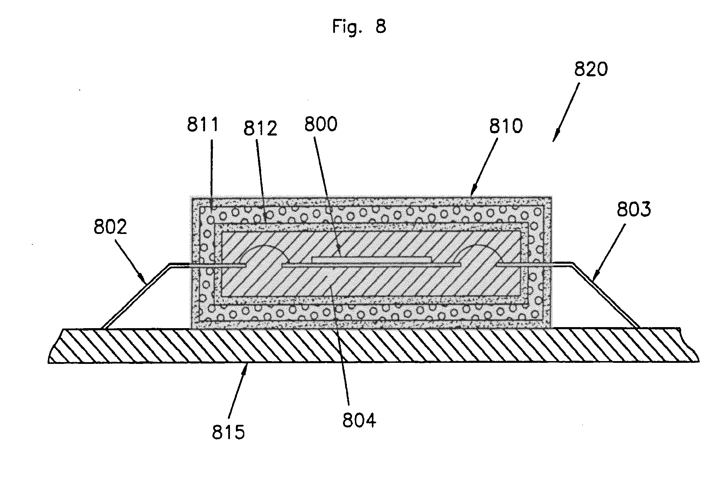

Knowing the spectrum of radiation for the application, the layering of the inventive shielding material is tailored as hereinafter described in greater detail with reference to FIG. 8. High Z material is more effective at stopping electrons and Bremsstrahlung radiation, and less effective in stopping protons. Low Z material conversely is more effective at stopping protons and less effective at stopping electrons and Bremsstrahlung radiation.

The next step, as indicated at 106, requires determining the form of the integrated circuit. For a prepackaged part, the amount of shielding is limited by the lead length on the bottom of the device, unless extenders are used. The most appropriate method of application of the shielding composition is then determined as indicated at 108. The part is coated in a mold (not shown), using a dam (not shown), and the coating can be globbed, sprayed, injected or painted on. For die that are already mounted on the board (not claimed), the methods mentioned above are effective, but to insure uniform radiation shielding, the bottom of the board underneath the part is also coated with the same thickness of the inventive shielding composition. The coating material is applied as indicated at 110 and then allowed to cure as indicated at 111. Temporary extenders are preferably used to provide thorough wetting throughout the binder. As an example, a preferred extender for epoxy is a high boiling point ketone.

Additionally, by adjusting the properties of the binder, the bulk electrical properties of the shield composition is adjusted to be either insulating or conductive.

Upon completion of coating the parts, testing is then performed electrically and mechanically, as indicated generally at 112. For space applications, the parts require space qualification testing.

There are various different methods of application of the shielding composition as indicated in FIGS. 5, 6, 7 and 8. However, the following examples are intended to be representative and not all inclusive of the possible application methods.

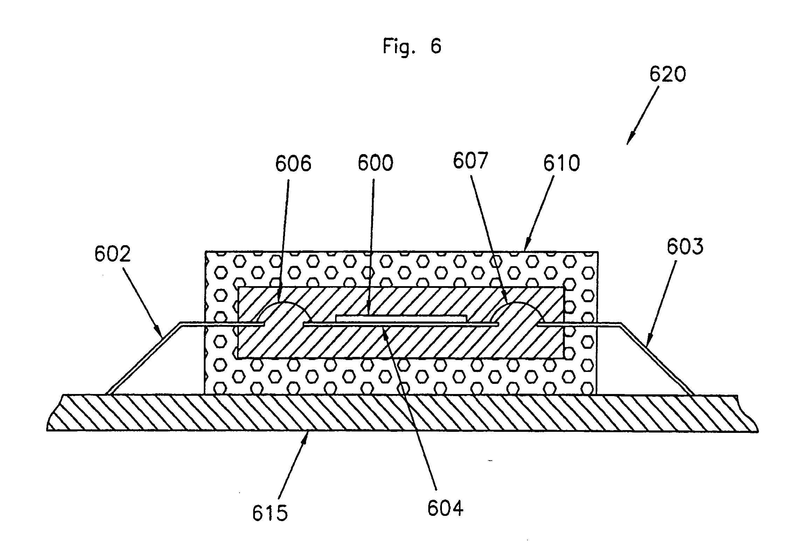

Referring now to FIG. 6, a coating method is illustrated for a die 600 attached to a substrate 604. It should be understood that a multiple die device, such as the one shown in FIG. 3, may also be protected as will become apparent to those skilled in the art.

The die is wire bonded at 606 and at 607 to lead frame devices 602 and 603, respectively, to complete electrical connections between the die and systems (not shown) outside of the package. A radiation shielding conformal coating composition is applied to the outside of the package 610. The package can then be applied to a board 615 or any other attachment system by any suitable conventional technique.

The radiation shielding conformal coating composition 610 is applied uniformly on the outer surface of the package to insure uniform radiation protection. The coating can be applied by injection molding, mold casting, spraying, globbing or brushing the material onto the part to be protected.

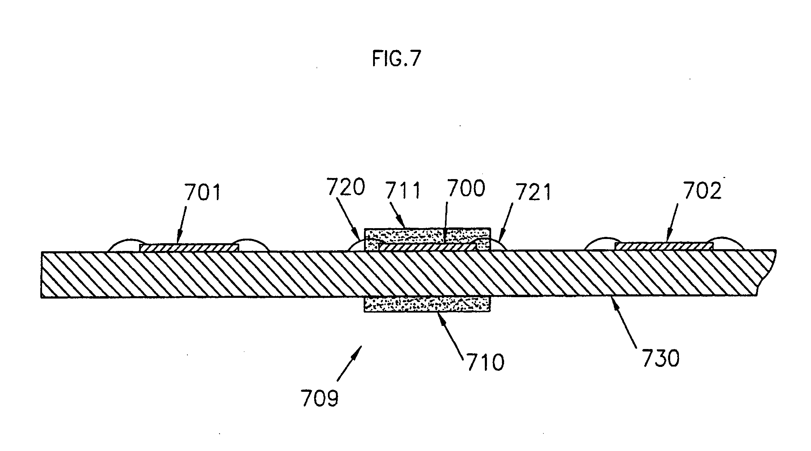

Referring now to FIG. 7, another method of application includes applying the radiation shielding conformal coating composition generally indicated at 709 to an integrated circuit device 700 previously attached to a board 730. The board 730 may have other devices such as a pair of devices 701 and 702 not requiring protection. The device 700 is attached to the board via wire bonds 720 and 721. The radiation shielding conformal coating composition 709 is then applied both on top of the device 700 at 711 and directly underneath the device 77 at 710 on the board 730.

An area greater than the size of the device 700 is covered with radiation shielding conformal coating composition 710 on the bottom of the board 730. This is required to insure that the entire integrated circuit device is protected from radiation.

The radiation shielding conformal coating composition 709 is applied by the same method as described in connection with the method of FIG. 6.

Referring now to FIG. 8, to enhance radiation shielding performance, multiple layers of the radiation shielding conformal coating composition are applied. Using conventional codes such as NOVICE, different shielding layering are developed for each type of orbit. An optimum shielding geometry for a Geosynchronous Orbit is shown in FIG. 8.

As shown in FIG. 8, in accordance with the present invention, an integrated circuit package 804 containing lead frame devices 802 and 803, and a die 800, is encased within a multiple layer radiation shielding composition generally indicated at 820, prior to mounting the shielded package to a board or substrate 815. The multiple layer shielding composition 820 comprises a layer of high Z particles 811 interposed between a pair of outer and inner layers of low Z particles 810 and 812. The low Z layer 812 is applied directly to the outer surface of the package 804 in accordance with the method described in connection with FIG. 6. Thereafter, the intermediate high Z layer 811 is then applied to the outer surface of the inner low Z layer 812.

The outer low Z layer 810 is then applied to the outer surface of the intermediate high Z layer 811 to complete the shielding protection for the die 800. The shielded package 804 is then connected electrically and mounted to the board 815 by conventional techniques.

The high Z material is effective in stopping electrons and Bremsstrahlung radiation, while the low Z material is more effective in stopping protons. A Geosynchronous orbit is dominated by trapped electrons, so it is preferable that the intermediate high Z layer 811, is thicker than the other two low Z layers. It will become apparent to those skilled in the art that the multiple layer coating method of the present invention can be used in connection with the protection of many different types and kinds of integrated circuit devices and the like. Additionally, the coating method can be applied by any method including, but not limited to, those described in connection with the method of FIG. 6.

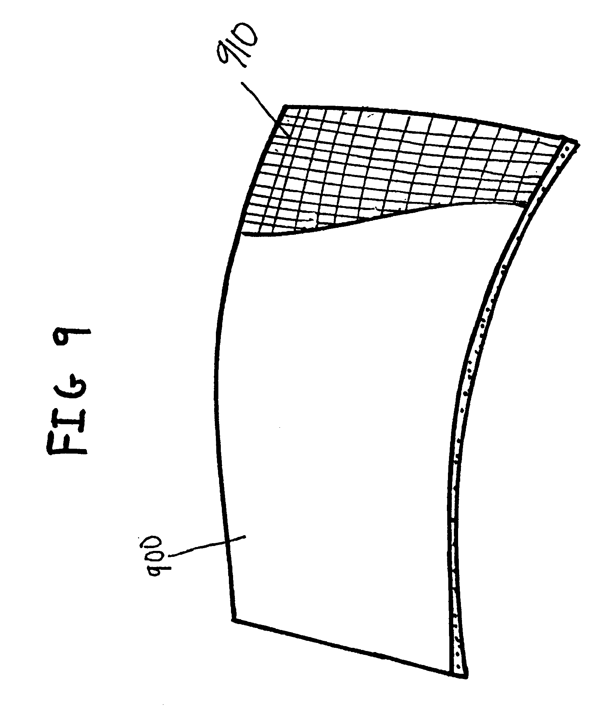

Referring to FIG. 9, there is shown a flexible shielding material. The material 900 contains the radiation shielding composition, and is flexible and pliable to serve as clothing for humans or gasket material for parts (not shown). The conformal coating material 900 includes a flexible binder such as latex. The material 900 is impregnated with a fabric such as a cloth woven material 910 for strength. The cloth material can be composed of conventional materials such as cotton or polyester. For extra strength, nonwoven fabric such as Kevlar or Teflon material can be used for the fabric.

Considering now the radiation shielding composition forming a part of the foregoing inventive method and device, the following examples of shielding compositions are given to aid in understanding the invention, but it is to be understood that the particular procedures, conditions and materials of these examples are not intended as limitations of the present invention.

### Example I

| | |
|---|---|
| 10.0 parts by weight | high tap density tungsten powder |
| 0.15 part by weight | premixed epoxy |
| up to 0.50 part by weight | ketone |

The tungsten powder serves as a high Z material for radiation shielding purposes. The epoxy serves as a binder to help adhere the composition to a surface, and the ketone is added as an extender.

To formulate the composition, the ingredients of Example I are mixed thoroughly, and then the mixture is applied to a part. The applied mixture is in the form of a paste, and is heated slowly at a suitable low temperature such as 40°C for about one hour to remove a substantial portion of the ketone extender without disrupting the integrity of the packed tungsten powder. The mixture is then heated at about 60°C for about 16 hours to retain the stability of the composition. The temperature is then increased to about 150°C for an additional period of time of about 0.5 hours. The resulting mixture has the desired consistency of a paste, and retains its stability due to the foregoing multiple heating phases.

### Example II

In general, the ingredients of the present Example can be adjusted to accommodate variations in the foregoing described inventive method and application.

A suitable high Z radiation shielding powder may be selected from osmium, iridium, platinum, tantalum and gold. In general, any high Z material may be employed having an atomic number of 50 and above. More preferably, the range of atomic numbers can be between 60 and 100, inclusive. The most preferred range of atomic numbers is between 73 and 79, inclusive.

The shielding also includes a low Z material, such as the one mentioned in connection with the description of the inventive method of FIG. 8. The low Z shielding powder is preferably selected from the group consisting of copper, nickel, carbon, titanium, chromium, cobalt, boron, silicon, iron and nitrogen. In general, any suitable low Z material may be employed having an atomic number of 30 and below, but the most preferred group of low Z materials is selected from the group consisting of copper, nickel, carbon, iron, titanium, silicon and nitrogen.

In general, the shielding powder can be any suitable material composed of a matrix of densely packed shielding particles. The preferred material is tungsten (Example 1) having a packing density of at least 150 grn per cubic inch (9.15 g/cm³).

There can be between about 0.10 and about 0.50 parts by weight of a binder in the form of a suitable resin. The binder can be a urethane. The exact quantity of the binder determines the final density and strength of the shielding afforded by the composition. A more preferred range of the binder is between about 0.13 and about 0.30.

Also, in general, the extender assures complete wetting of the powders and adjusts the viscosity of the paste to suit the application method.

### Example III

| | |
|---|---|
| 10.0 parts by weight | high tap density tungsten powder |
| 0.15 part by weight | premixed epoxy |
| up to 0.50 part by weight | latex |

This example of the material may be used for the method described in connection with FIG. 9, wherein a fabric may be embedded therein for reinforcing purposes. Any suitable elastomer may be employed for the latex.

While particular embodiments of the present invention have been disclosed, it is to be understood that various different modifications are possible and are contemplated within the scope of the appended claims. There is no intention, therefore, of limitations to the exact abstract or disclosure herein presented.

## Claims

1. A radiation shielding structure (820), comprising:
- a circuit package (804) packaging:
- a die (800), and
- a lead frame (802, 803),
wherein the circuit package is encased in a multiple layer shielding (820), the multiple layer shielding (820) comprising:
a conformal coating composed of a layer (811) of high Z shielding particles, the high Z material having an atomic number of 50 and above, interposed between an outer and an inner layer (810, 812) of low Z shielding particles, the low Z material having an atomic number of 30 and below, wherein each one of said shielding particles is encapsulated within a binder, the inner layer (812) being applied directly to the outer surface of the circuit package (804).

2. A radiation shielding structure according to claim 1, wherein the particles of the two layers of low Z shielding particles are selected from the group consisting of copper, nickel, carbon, iron, titanium, silicon, boron and cobalt.

3. A radiation shielding structure according to any of claims 1 to 2, wherein said layer (811) of high Z shielding particles is thicker than the other two layers (810, 812) of low Z shielding particles.

4. The shielding structure of any of claims 1 to 3, wherein said layer of high Z shielding particles (811) comprises a binder in a proportion of about 0.13 to about 0.30 part by weight of the layer of high Z shielding particles (811), wherein each one of said shielding particles is encapsulated within said binder.

5. A method for making a radiation shielding structure according to any of claims 1 to 4, comprising:
- applying the inner layer of low Z material (812) to an outer surface of said package using injection molding, or mold casting or spraying or globbing or painting or brushing the material of said layer of low Z material;
- applying said layer (811) of high Z shielding particles to the outer surface of said inner layer of low Z material (812);
- applying the outer layer of low Z material (810) to the outer surface of said layer (811) of high Z shielding particles.

## Patentansprüche

1. Strahlungsabschirmungsstruktur (820) umfassend:
- Ein Schaltungsgehäuse (804) mit darin:
- Einem Chip (800), und
- einem Leitungsrahmen (802, 803),
wobei das Schaltungsgehäuse in eine Mehrschichtenabschirmung (820) eingeschlossen ist, wobei die Mehrschichtenabschirmung (820) umfasst:
Eine konforme Beschichtung, gebildet aus einer Schicht (811) aus Abschirmungspartikeln mit großem Z, wobei das Material mit großem Z eine Atomzahl von 50 und darüber hat, eingefügt zwischen einer äußeren und einer inneren Schicht (810, 812) aus Abschirmungspartikeln mit kleinem Z, wobei das Material mit kleinem Z eine Atomzahl von 30 und darunter hat, wobei jedes der Abschirmungspartikel innerhalb eines Binders eingekapselt ist, wobei die innere Schicht (812) direkt auf der Außenoberfläche des Schaltungsgehäuses (804) aufgebracht ist.

2. Strahlungsabschirmungsstruktur nach Anspruch 1, wobei die Partikel der zwei Schichten aus Abschirmpartikeln mit kleinem Z ausgewählt sind aus der Gruppe bestehend aus Kupfer, Nickel, Kohlenstoff, Eisen, Titan, Silizium, Bor und Kobalt.

3. Strahlungsabschirmungsstruktur nach einem der Ansprüche 1 bis 2, wobei die Schicht (811) aus Abschirmungspartikeln mit großem Z dicker ist als die zwei anderen Schichten (810, 812) aus Abschirmungspartikeln mit kleinem Z.

4. Abschirmungsstruktur nach einem der Ansprüche 1 bis 3, wobei die Schicht aus Abschirmungspartikeln mit großem Z (811) einen Binder in einem Verhältnis von ungefähr 0,13 bis ungefähr 0,30 Gewichtsanteilen der Schicht aus Abschirmpartikeln mit großem Z (811) umfasst, wobei jedes der Abschirmpartikel innerhalb des Binders eingekapselt ist.

5. Verfahren zur Herstellung einer Strahlungsabschirmungsstruktur nach einem der Ansprüche 1 bis 4, umfassend:
- Aufbringen der inneren Schicht aus Material mit kleinem Z (812) auf eine Außenoberfläche des Gehäuses unter Verwendung von Spritzgießen oder Formgießen oder Sprühen oder Globbing oder Lackieren oder Aufstreichen des Materials der Schicht aus Material mit kleinem Z;
- Aufbringen der Schicht (811) aus Abschirmungspartikeln mit großem Z auf die Außenoberfläche der inneren Schicht aus Material mit kleinem Z (812);
- Aufbringen der äußeren Schicht aus Material mit kleinem Z (810) auf die Außenoberfläche der Schicht (811) aus Abschirmungspartikeln mit großem Z.

## Revendications

1. Structure de protection contre le rayonnement (820) comprenant :
un boîtier de circuit (804) comprenant :
une matrice (800), et
une grille de connexion (802, 803),
dans laquelle le boîtier de circuit est enfermé dans un bouclier multicouche (820), le bouclier multicouche (820) comprenant :
un revêtement enrobant composé d'une couche (811) de particules de protection à valeur de Z élevée, le matériau à valeur de Z élevée ayant un numéro atomique de 50 et supérieur, intercalé entre une couche externe et une couche interne (810, 812) de particules de protection à valeur de Z basse, le matériau à valeur de Z basse ayant un numéro atomique de 30 et inférieur, dans laquelle chacune desdites particules de protection est encapsulée à l'intérieur d'un liant, la couche interne (812) étant directement appliquée sur la surface externe du boîtier de circuit (804).

2. Structure de protection contre le rayonnement selon la revendication 1, dans laquelle les particules des deux couches de particules de protection à valeur de Z élevée sont choisies dans le groupe comprenant le cuivre, le nickel, le carbone, le fer, le titane, le silicium, le bore et le cobalt.

3. Structure de protection contre le rayonnement selon l'une quelconque des revendications 1 à 2, dans laquelle ladite couche (811) de particules de protection à valeur de Z élevée est plus épaisse que les deux autres couches (810, 812) de particules de protection à valeur de Z basse.

4. Structure de protection selon l'une quelconque des revendications 1 à 3, dans laquelle ladite couche de particules de protection à valeur de Z élevée (811) comprend un liant dans une proportion d'environ 0,13 à environ 0,30 part en poids de la couche de particules de protection à valeur de Z élevée (811), dans laquelle chacune desdites particules de protection est encapsulée à l'intérieur dudit liant.

5. Procédé pour réaliser une structure de protection contre le rayonnement selon l'une quelconque des revendications 1 à 4, comprenant les étapes consistant à :
appliquer la couche interne de matériau à Z bas (812) sur une surface externe dudit boîtier à l'aide du moulage par injection ou en coulant en moule ou en pulvérisant ou en englobant ou en peignant ou en brossant le matériau de ladite couche de matériau à valeur de Z basse ;
appliquer ladite couche (811) de particules de protection à valeur de Z élevée sur la surface externe de ladite couche interne de matériau à valeur de Z basse (812) ;
appliquer la couche externe de matériau à valeur de Z basse (810) sur la surface externe de ladite couche (811) de particules de protection à valeur de Z élevée.
